Europäisches Patentamt

European Patent Office

Office européen des brevets

(19)

(11) **EP 0 746 069 B1**

(12) **EUROPEAN PATENT SPECIFICATION**

(45) Date of publication and mention
of the grant of the patent:
**22.12.1999 Bulletin 1999/51**

(51) Int Cl.$^6$: **H01S 3/133**, H01S 3/043

(21) Application number: **96111053.3**

(22) Date of filing: **30.05.1994**

(54) **Frequency stabilization method of semiconductor laser and frequency-stabilized light source**

Frequenzstabilisationsverfahren für Halbleiterlaser und frequenzstabilisierte Lichtquelle

Méthode de stabilisation de la fréquence d'un laser à semi-conducteur et source de lumière stabilisée en fréquence

(84) Designated Contracting States:
**DE FR GB**

(30) Priority: **31.05.1993 JP 12656993**

(43) Date of publication of application:
**04.12.1996 Bulletin 1996/49**

(62) Document number(s) of the earlier application(s) in
accordance with Art. 76 EPC:
**94105059.3 / 0 618 653**

(73) Proprietor: **NEC CORPORATION**
**Tokyo (JP)**

(72) Inventors:
• **Shiozawa, Takahiro**
**Minato-ku, Tokyo (JP)**
• **Henmi, Naoya**
**Minato-ku, Tokyo (JP)**

(74) Representative: **Glawe, Delfs, Moll & Partner**
**Patentanwälte**
**Postfach 26 01 62**
**80058 München (DE)**

(56) References cited:
• **PATENT ABSTRACTS OF JAPAN vol. 011, no. 288 (E-542), 17 September 1987 & JP-A-62 089378 (MATSUSHITA ELECTRIC IND CO LTD), 23 April 1987,**
• **IEEE TRANSACTIONS ON INSTRUMENTATION AND MEASUREMENT, vol. 36, no. 3, 3 September 1987, NEW YORK, US, pages 789-796, XP002009943 S.YAMAGUCHI ET AL.: "Power level controlled optical sweep oscillator using a GaAs semiconductor laser"**
• **ELECTRONICS LETTERS, vol. 26, no. 6, 15 March 1990, STEVENAGE, GB, pages 405-406, XP000122770 NAKAMURA M S ET AL: "Frequency-stabilized LD module with a z-cut quartz Fabry-Perot resonator for coherent communication"**
• **ELECTRONICS LETTERS, vol. 22, no. 10, 8 May 1986, STEVENAGE, GB, pages 553-554, XP002009944 H.TUCHIDA ET AL.: "Wideband frequency scanning of a stabilized semiconductor laser"**

**Description**

BACKGROUND OF THE INVENTION

1. Field of the Invention

The present invention relates to a semiconductor laser and more particularly, to a frequency stabilization method of a semiconductor laser and a frequency-stabilized light source.

2. Description of the prior art

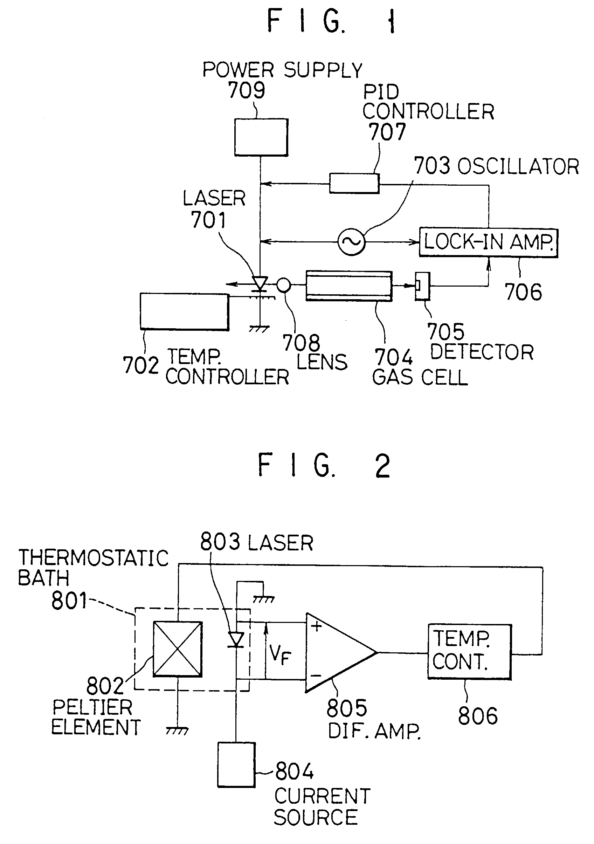

A conventional frequency stabilization method of a semiconductor laser is disclosed in the IEEE Journal of Quantum Electronics, Vol. 28, No. 1, Page 75, January 1992, in which an oscillation frequency of the laser is stabilized at an absorption line frequency of acetylene. Fig. 1 shows a functional block diagram of the conventional frequency stabilization method.

In Fig. 1, the ambient temperature of a semiconductor laser 701 is kept constant by a temperature controller 702. A DC power supply 709 supplies a driving current to the laser 701. The driving current is slightly modulated in frequency by a modulation signal outputted from an oscillator 703, resulting in frequency-modulated output light beams of the laser 701.

One of the output light beams of the laser 701 is emitted from a side face of the laser 701 and used for a given application. The other of the output light beams of the laser 701 is emitted from its opposite side face and goes through an optical lens system 708 to be injected into an acetylene ($C_2H_2$) gas cell 704. The light beam transmitted through the acetylene gas cell 704 is detected by a photodetector 705 to produce an electrical output signal. The electrical output signal is inputted into an lock-in amplifier 706 to be detected synchronously with the modulation frequency from the oscillator 703.

The lock-in amplifier 706 produces an electrical output signal proportional to a difference or error between the oscillation frequency of the laser 701 and one of absorption peak frequencies of acetylene in the cell 704. The electrical output signal from the amplifier 706 is fed-back to the driving current through a PID controller 707 in which a Proportional, Integral and Differential (PID) controlling method is employed. Thus, the laser 701 is controlled so that its oscillation frequency is kept to be in accordance with the absorption peak frequency of acetylene.

Due to high stability in the absorption peak frequency, the oscillation frequency of the semiconductor laser 701 can be highly stabilized or locked.

With the conventional frequency stabilization method shown in Fig. 1, to obtain the difference or error between the oscillation frequency and the absorption peak frequency, the gas cell 704 and the lock-in amplifier 706 are required, and the driving current is modulated in frequency to be injected into the laser 701. As a result, there arises disadvantages that large-sized and expensive setups or apparatuses are necessary for carrying out the method and no unmodulated output light beam can be obtained.

In the case of stabilizing the optical output power of the laser 701 during operation, there is another disadvantage that another photodetector is necessary in addition to the photodetector 705.

Further, there is still another disadvantage that stabilizable oscillation frequencies are restricted to the absorption peak frequencies of the gas in the cell 704, so that any or arbitrary oscillation frequencies cannot be selected.

IEEE Transactions on Instrumentation and Measurement, vol.36, no.3, 3 September 1987, P. 789-796, describes the simultaneous stabilization of the frequency and the output power of a semiconductor laser using an interferometer as a frequency reference.

Another conventional frequency stabilization method of a semiconductor laser is disclosed in the Japanese Non-Examined Patent. Publication No. 64-74780, March 1989, in which a semiconductor laser temperature is detected from a forward voltage of the laser to keep the temperature constant. Fig. 2 shows a functional block diagram of the conventional frequency stabilization method.

In Fig. 2, a semiconductor laser 803 and a Peltier element 802 which generates and absorbs heat are arranged in a thermostatic bath 801. The laser 803 is driven by a constant current supplied from a DC current source 804. A differential amplifier 805 detects between input terminals or electrodes of the laser 803 its forward voltage drop $V_f$, and sends an electrical output signal proportional the voltage drop $V_f$ to a temperature controller 806.

In response to the output signal from the amplifier 805, the controller 806 increases or decreases a driving current for the Peltier element 801 to thereby keep the temperature of the laser 803 constant.

In general, the forward voltage drop $V_f$ of the semiconductor laser 803 is expressed as

$$V_f = \frac{k \cdot I_n \left(1 + \frac{I_f}{I_0}\right)}{e \cdot T} \qquad (1)$$

where $I_0$ is the forward saturation current, $I_f$ is a driving or exciting current, T is the absolute temperature of the laser 803, e is the charge of an electron and k is the Boltzmann's constant.

To be seen from the equation (1), the forward voltage drop $V_f$ is inversely proportional to the absolute temperature T. Thus, the absolute temperature T of the laser 803 can be exactly measured from the voltage drop $V_f$.

The differential amplifier 805 produces an output signal relating to the absolute temperature T from the detected voltage drop $V_f$ and sends the signal to the temperature controller 806. In response to the signal, the controller 806 controls to keep the temperature of the laser 803 constant.

The oscillation frequency of the semiconductor laser 803 is decided by the absolute temperature T and driving current $I_f$, so that it can be seen that the oscillation frequency is stabilized if both of them are kept constant.

With the another conventional frequency stabilization method shown in Fig. 2, an error tends to arise in detection of the absolute temperature T through the differential amplifier 805 because the laser 803 has an leakage current and a recombination current without luminescence both of which increase with the passage of time, providing fluctuation or deviation in the absolute temperature T and driving current $I_f$.

As a result, there arises a disadvantage that the output light power and oscillation frequency of the laser 803 deviate from the given values, respectively.

In addition to the above methods, still another conventional frequency stabilization method of a semiconductor laser is disclosed in the Japanese Non-Examined Patent Publication No. 1-238083, September 1989. In the method, similar to the conventional method shown in Fig. 2, absorption peak frequencies of a gas is used.

Another known frequency stabilisation method of a semiconductor laser is known from Patent Abstracts of Japan, vol. 011, no.288 (E-542), 17 September 1987; & JP-A-62089378, 23 April 1987.

SUMMARY OF THE INVENTION

An object of the present invention is to provide a frequency stabilization method of a semiconductor laser and a frequency-stabilized light source in which only a simple, compact and low-cost setup is necessary.

A further object of the present invention is to provide a frequency stabilization method of a semiconductor laser and a frequency-stabilized light source in which an output light power and an oscillation frequency of the semiconductor laser can be maintained even if the laser operates for a long period of time.

Another object of the present invention is to provide a frequency stabilization method of a semiconductor laser and a frequency-stabilized light source in which unmodulated light output can be obtained.

Still another object of the present invention is to provide a frequency stabilization method of a semiconductor laser and a frequency-stabilized light source in which both of the oscillation frequency and the output light power of the laser can be stabilized.

Still another object of the present invention is to provide a frequency-stabilized semiconductor laser module which enables the semiconductor laser to operate stably.

These objects are achieved by a frequency stabilisation method according to claim 1, a frequency-stabilized light source according to claim 2.

According to an aspect of the present invention, a frequency stabilization method of a semiconductor laser is provided in accordance with claim 1, which includes the steps of injecting an output light beam from a semiconductor laser into an optical resonator, to produce a transmitted light having a peak frequency of the optical resonator, detecting the transmitted light beam having the peak frequency to produce an output signal about a detected power of the transmitted light beam, controlling the power of the transmitted light beam to be kept constant based on the output signal, and controlling an oscillation frequency of the semiconductor laser to be in accordance with the peak frequency.

With the above frequency stabilization method of a semiconductor laser, no gas cell is required, so that only a simple, compact and low-cost setup is sufficient for the method.

Since the power of the transmitted light beam is controlled to be kept constant and at the same time, the oscillation frequency of the laser is controlled to be in accordance with the peak frequency, both of the oscillation frequency and the output light power of the laser can be stabilized.

According to a further aspect of the present invention, a frequency-stabilized light source is provided in accordance with claim 2, which enables the above method to be carried out.

The light source includes a semiconductor laser emitting an output light beam, an optical resonator into which the output light beam is injected, the resonator producing a transmitted light beam and having a peak frequency of the transmitted light beam, a detector for detecting the transmitted light beam to produce an output signal about a detected power of the transmitted light beam, a first controller for controlling the power of the transmitted light beam to be kept constant based on the output signal, and a second controller for controlling an oscillation frequency of the semiconductor laser to be in accordance with the peak frequency.

BRIEF DESCRIPTION OF THE DRAWINGS

Fig. 1 is a functional block diagram showing a conventional frequency stabilization method of a semiconductor laser.

Fig. 2 is a functional block diagram showing another conventional frequency stabilization method of a semiconductor laser.

Fig. 3 is a functional block diagram of a frequency-stabilized light source according to a first example not in accordance with the invention.

Fig. 3A schematically shows a cross section of a semiconductor laser used in the light source shown in Fig. 3.

Fig. 4 is a functional block diagram of a frequency-stabilized light source according to a second example not in accordance with the present invention.

Fig. 5 is a functional block diagram of a frequency-stabilized light source according to a first embodiment of the present invention.

Fig. 6 is a functional block diagram of a frequency-stabilized light source according to a third example not in accordance with the present invention.

Fig. 7 is a functional block diagram of a frequency-stabilized light source according to a second embodiment of the present invention.

DETAILED DESCRIPTION OF THE PREFERRED EMBODIMENTS

Preferred embodiments of the present invention will be described below while referring to the drawings attached.

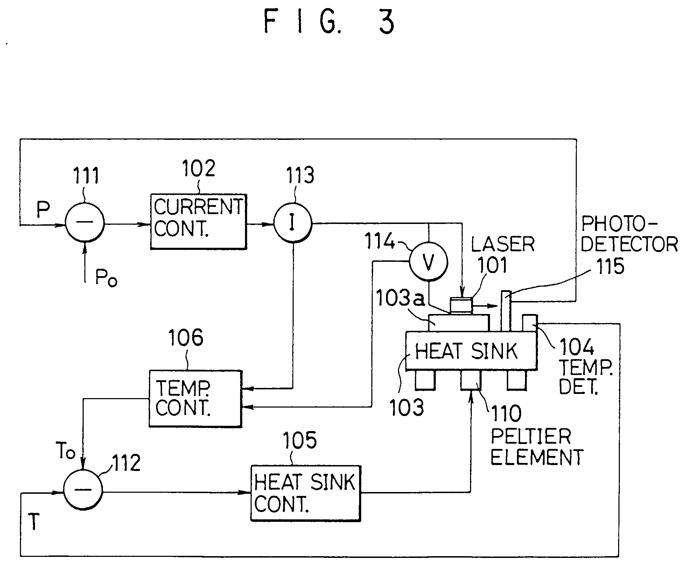

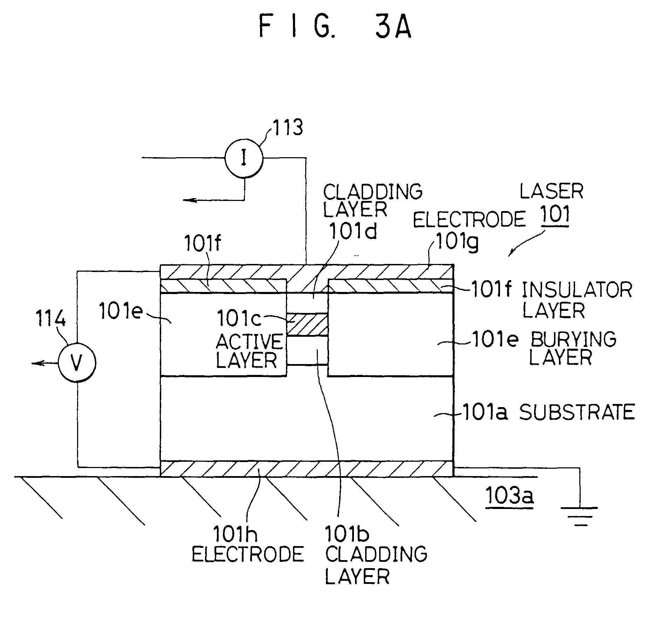

In Fig. 3, which shows a frequency-stabilized light source according to a first example not in accordance with the invention, a semiconductor laser 101 is mounted on a heat sink 103 through a subcarrier 103a. A photodetector 115 fixed on the heat sink 103 receives an output light beam of the laser 101 to detect its power and outputs an electrical signal corresponding to the detected power P to a first subtractor 111.

The first subtractor 111 produces by subtraction a difference between the detected power P and the predetermined reference power $P_0$ and outputs an electrical signal corresponding to the power difference thus produced to a current controller 102. In response to this signal, the current controller 102 controls to increase or decrease a driving current for the laser 101 in order to keep or stabilize the power of the output light beam at $P_0$.

A current detector 113 is arranged in a current path between the current controller 102 and the laser 101 to detect the driving current. The current detector 113 outputs an electric signal corresponding to the driving current thus detected to a temperature controller 106. Thus, the driving current is always monitored by the temperature controller 106 during operation.

A voltage detector 114 is electrically connected between input terminals of the laser 101 to detect the voltage therebetween. The voltage detector 114 outputs an electric signal corresponding to the inter-terminal voltage thus detected to the temperature controller 106. Thus, the forward voltage of the laser 101 is always monitored by the temperature controller during operation.

The temperature controller 106 carries out a mathematical operation to get the consumption power of the laser 101 based on the output signals from the current and voltage detectors 113 and 114. Then, the controller 106 increases or decreases the reference temperature $T_0$ of the heat sink 103 based on the result of the operation and sends an electric signal corresponding to the reference temperature $T_0$ to a second subtractor 112.

A temperature detector 104 fixed on the heat sink 103 detects the temperature of the heat sink 103. The detector 104 produces an electric signal corresponding to the detected temperature T to send the signal to the second subtractor 112.

The second subtractor 112 produces by subtraction a difference between the detected temperature T and the reference temperature $T_0$ and outputs an electrical signal corresponding to the temperature difference thus produced to a heat sink controller 105. In response to this signal, the heat sink controller 105 increases or decreases the temperature of the heat sink 103 in order to keep or stabilize the temperature at $T_0$.

The temperature control by the heat sink controller 105 is carried out using Peltier elements 110 attached to the heat sink 103. Since the Peltier elements 110 generate or absorb heat depending upon its driving current, the temperature of the heat sink 103 can be increased or decreased precisely by the elements 110.

Fig. 3A shows a cross section of the semiconductor laser 101 used in the light source shown in Fig. 3. In Fig. 3A, on the surface of a semiconductor substrate 101a, a strip portion formed of an active layer 101c and upper and lower cladding layers 101d and 101b respectively disposed on upper and lower sides of the active layer 101c. The strip portion is bounded on its each side by a pair of burying layers 101e formed on the surface of the substrate 101a.

A pair of insulator layers 101f are formed on the surfaces of the pair of the burying layers 101e, respectively. An upper electrode or terminal 101g is formed on the surfaces of the insulator layers 101f and the upper cladding layer 101d. A lower electrode or terminal 101h is formed on the back surface of the substrate 101a. The laser 101 is fixed to the subcarrier 103a through the lower electrode 101h.

The pair of the burying layers 101e act as current blocking layers for narrowing the driving current path.

The current detector 113 is electrically connected to the upper electrode 101g and the voltage detector 114 is electrically connected to the upper and lower electrodes 101g and 101h.

Next, the frequency stabilization operation of the semiconductor laser 101 is described below.

The semiconductor laser 101 tends to show a drift or deviation in oscillation frequency in a long period of time when the driving current is controlled so that the output light power of the laser 101 is kept constant and at the same time, the controlling current for the Peltier elements 110 is controlled so that the temperature of the heat sink 103 is kept constant.

It is considered that the drift or deviation in oscillation frequency is caused by change in percentage which contributes the laser oscillation within the total driving current injected into the laser 101. The change in percentage contributing laser oscillation is considered to be caused by (a) increase in leakage current due to deterioration of the current blocking layers or the pair of the burying layers 101e, and by (b) increase in recombination current without luminescence due to deterioration of the active layer 101c.

For example, when both of the output light power and the temperature are kept constant, the driving current percentage contributing laser oscillation tends to decrease, and the driving current increases to compensate the percentage decrease. Thus, the temperature of the active layer 101c rises in response to the increase in the driving current and as a result, the oscillation frequency of the laser 101 will drift toward the lower frequency side.

The drift $\Delta f$ of the oscillation frequency can be expressed as follows:

It is hardly considered that because an optical loss within the semiconductor laser 101 changes during operation in the long period of time, the carrier density in the laser 101 is kept substantially constant during operation and as a result, the oscillation frequency is not affected by the optical loss. Therefore, it is considered that the frequency change or drift $\Delta f$ is caused by the temperature change $\Delta T$ of the active layer 101c.

Under the first order approximation, the frequency change $\Delta f$ can be expressed as

$$\Delta f = \frac{\delta f}{\delta T} \bullet \Delta T \qquad (2)$$

The equation (2) means that the frequency change $\Delta f$ is zero if the temperature of the active layer 101c is constant, that is, the temperature difference $\Delta T$ is zero.

The temperature of the semiconductor laser 101 can be controlled to be kept constant by the heat sink controller 105, however, there arises a temperature difference between the active layer 101c and the heat sink 103 because of heat resistance between the active layer 101c and the temperature detector 104 when the consumption power of the laser 101 changes.

The temperature change $\Delta T$ of the active layer 101c is expressed as

$$\Delta T = \theta \bullet \Delta W + \Delta T_0 \qquad (3)$$

where $\Delta W$ is the consumption power change of the active layer 101c, $\theta$ is the heat resistance between the active layer 101c and the temperature detector 104 and $\Delta T_0$ is the change of the reference temperature of the heat sink 103.

Consequently, it is seen that the temperature change $\Delta T_0$ can be cancelled if the following equation (4) is established, resulting in a stabilized oscillation frequency.

$$\Delta T_0 = -\theta \bullet \Delta W \qquad (4)$$

Here, the total driving current $i_t$ and the forward voltage v between the input electrodes 101g and 101h can be expressed as the following equations (5a) and (5b) using the initial, total driving current $i_{t0}$, the initial forward voltage $v_0$, the change $\Delta i_t$ of the total driving current $i_t$, and the change $\Delta v$ of the forward voltage.

$$i_t = i_{t0} + \Delta i_t \qquad (5a)$$

$$v = v_0 + \Delta v \qquad (5b)$$

From the equations (5a) and (5b), the consumption power change $\Delta W$ of the active layer 101c can be expressed as

$$\Delta W = W - W_0 = i_t \bullet v - i_{t0} \bullet v_0$$

$$= \Delta i_t \bullet v_0 + it_0 \bullet \Delta v + \Delta i_t \bullet \Delta v \qquad (6)$$

The reference temperature $T_0$ of the heat sink 103 is controlled by the heat sink controller 105 so that the consumption power change $\Delta W$ expressed by the equation (6) is cancelled.

The temperature controller 106 calculates in value the consumption power change $\Delta W$ using the equations (4) and (6) based on the electric signals from the current and voltage detectors 113 and 114. Then, the controller 106 adjusts in value the reference temperature $T_0$ to cancel the calculated value of the consumption power change $\Delta W$.

As described above, with the light source according to the first example, the current controller 102 controls the driving current for the semiconductor laser 101 so that the output light power of the laser 101 is kept constant, and at the same time, the temperature controller 106 and the heat sink controller 105 control the reference temperature $T_0$ of the heat sink 103 so that the temperature change of the active layer 101c is cancelled.

As a result, the oscillation frequency of the laser 101 can be stabilized because of no oscillation frequency drift due to electrical and optical characteristic changes of the laser 101 with passage of time.

Additionally, no gas cell and no synchronous detection means such as a lock-in amplifier are required, so that there arises an advantage that a simple, compact and low-cost setup is sufficient for the light source.

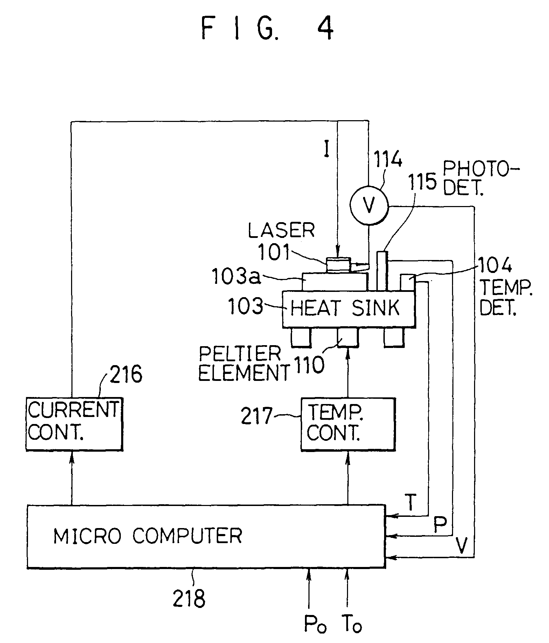

Fig.4 shows a frequency-stabilized light source according to a second example not in accordance with the present invention. In Fig. 4, the same reference numerals as those in Fig. 3 are attached to the corresponding elements for the sake of simplification of description and illustration.

A current control circuit 216 for controlling the driving current I for the semiconductor laser 101, a temperature control circuit 217 for controlling the temperature of the heat sink 103, and a micro computer 21 for controlling the circuits 216 and 217 are provided instead of the current controller 102, the temperature controller 106 and the heat sink controller 105 in Fig. 3.

The temperature detector 104 sends an electric signal corresponding to the detected temperature T of the heat sink 103 to the.micro computer 218. The photodetector 115 sends an electric signal corresponding to the detected light power P of the laser 101 to the micro computer 218. The voltage detector 114 sends an electric signal corresponding to the detected voltage V of the laser 101 to the micro computer 218.

The micro computer 218 is storing data relating the reference power $P_0$ and the reference temperature $T_0$ in advance. The computer 218 calculates data using the signal about the output light power P from the photodetector 115 and sends the data to the current control circuit 216. In response to the data thus sent, the current control circuit 216 controls to supply the driving current to the semiconductor laser 101, so that the output light power from the laser 101 is kept constant.

On the other hand, the computer 218 calculates data using the signals about the forward voltage V from the voltage detector 114 and the temperature T from the temperature detector 104, and sends the data to the temperature control circuit 217. In response to the data thus sent, the temperature control circuit 217 controls to supply the driving current to the Peltier elements 110, so that the reference temperature $T_0$ of the heat sink 103 is adjusted in order to cancel the temperature change of the active layer 101c.

Therefore, in the second example, the same effects as those the first example can be obtained. Additionally, there is an advantage that the configuration or setup can be made simpler than that of the first example because of the micro computer 218.

[First Embodiment]

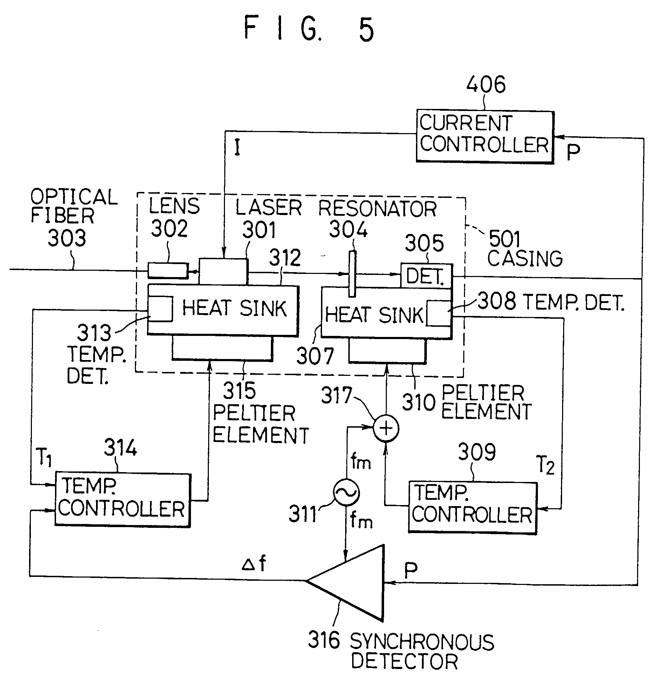

Fig.5 shows a frequency-stabilized light source according to a first embodiment of the present invention.

In Fig. 5, a semiconductor laser 301, which is fixed on a first heat sink 312, emits an output light beam from its one side face and the emitted light beam is injected into an optical fiber 303 optically coupled with the laser 101 through a lens system 302.

A first temperature detector 313 and a first Peltier element 315 are fixed to the first heat sink 312. The detector 313 and the element 315 act to control the temperature of the first heat sink 312 together with a first temperature controller 314, providing the temperature control of the laser 301.

The first temperature controller 314 receives an electric signal about the temperature $T_1$ of the first heat sink 312 from the first temperature detector 313. On the other hand, the first temperature controller 314 receives an electric signal about the frequency difference or drift $\Delta f$ from a synchronous detector 316. Based on the signals thus received, the controller 314 controls a driving current for the first Peltier element 315 to increase or decrease the temperature of the first heat sink 312.

Thus, the temperature $T_1$ of the semiconductor laser 301 is controlled to be kept constant.

Another output light beam of the laser 301 is emitted from its opposite side face and is injected into an optical resonator 304 fixed on a second heat sink 307. The optical resonator 304 is composed of, for example, an optical filter formed of a dielectric multilayer film, a Fabry-Perot etalon or the like. The second heat sink 307 is arranged apart from and adjacent to the first heat sink 312.

The light beam transmitted through the optical resonator 304 goes into a photodetector 305 fixed on the second heat sink 307. The photodetector 305 produces an electric signal corresponding to the detected power P of the light beam and sends the signal to a current controller 406 and the synchronous detector 316.

The current controller 406 controls a driving current I for the laser 301 so that the average output from the photodetector 305 is kept constant.

A second temperature detector 308 and a second Peltier element 310 are fixed to the second heat sink 307. The detector 308 and the element 310 act to control the temperature of the second heat sink 307 together with a second temperature controller 309, providing the temperature control of the optical resonator 304.

The second temperature controller 309 receives an electric signal corresponding to the detected temperature $T_2$ of the second heat sink 307 from the second temperature detector 308. Based on the signal thus received, the controller 309 controls a driving current for the second Peltier element 310 to increase or decrease the temperature of the second heat sink 307.

The output signal from the second temperature controller 309 is slightly modulated by a modulation signal and is sent to the second Peltier element 310. The modulation signal is supplied from an oscillator 311 and whose frequency is $f_m$.

Thus, the temperature of the optical resonator 304 is modulated by the modulation signal and at the same time, the temperature $T_2$ is controlled so that the time average of the temperature $T_2$ is kept constant.

The synchronous detector 316 detects the output signal from the photodetector 305 synchronously with the modulation signal from the oscillator 311. The optical resonator 304 such as a dielectric multilayer film filter or a Fabry-Perot etalon has a peak frequency for the transmitted light beam, which can be approximated by the Lorentz function or Gauss function. In addition, an electric output signal from the synchronous detector 316 has a waveform equal to the primary-differentiated waveform of the transmitted light beam at the peak frequency, so that the output signal is approximately proportional to the difference $\Delta f$ between the frequency of the output light beam injected into the optical resonator 304 and the peak frequency of the transmitted light beam through the resonator 304. This means that the electrical output signal from the synchronous detector 316 is available as a signal showing the frequency difference or error $\Delta f$.

The output signal from the synchronous detector 316 is sent to the first temperature controller 314. Then, the temperature of the semiconductor laser 301 is controlled by the controller 314 so that the oscillation frequency of the output light beam from the laser 301 is kept in accordance with the peak frequency of the transmitted light beam through the optical resonator 304. As a result, the oscillation frequency of the output light from the laser 301 is kept constant.

In the first embodiment, similar to the first and second examples, since no gas cell is necessary, a simple, compact and low-cost light source can be realized. Since the driving current is not modulated, an unmodulated output light can be provided easily.

Also, the semiconductor laser 301, the optical lens system 302, the optical resonator 304, the photodetector 305, the first and second heat sinks 312 and 307, the first and second temperature detectors 313 and 308, and the first and second Peltier elements 315 and 310 are incorporated into a casing 501, providing a semiconductor laser module. Therefore, there is an advantage of more stable operation and more compact size.

In addition, stabilization in both oscillation frequency and output light power can be realized only by the photodetector 305.

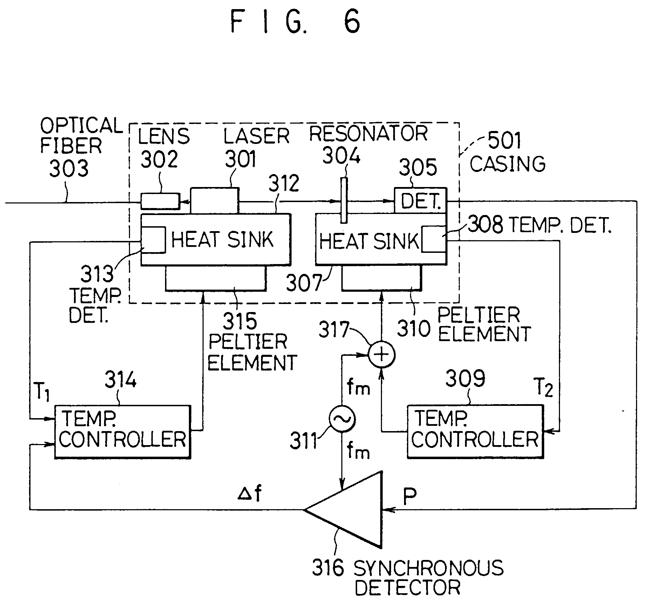

Fig.6 shows a frequency-stabilized light source according to a third example not in accordance with the invention, which is the same configuration as that of the first embodiment excepting that the current controller 406 in the first embodiment is omitted.

In the third example, in response to the detected power P of the light beam transmitted through the optical resonator 304, the photodetector 305 produces an electric signal corresponding to the detected power P and sends the signal only to the synchronous detector 316. The driving current I for the laser 301 is not controlled because of no current controller.

Since the driving current I for the semiconductor laser 301 is not controlled, the power of the output light beam from the laser 301 does not necessarily stabilized, however, there is an advantage that the configuration becomes simpler than that of the first embodiment.

[Second Embodiment]

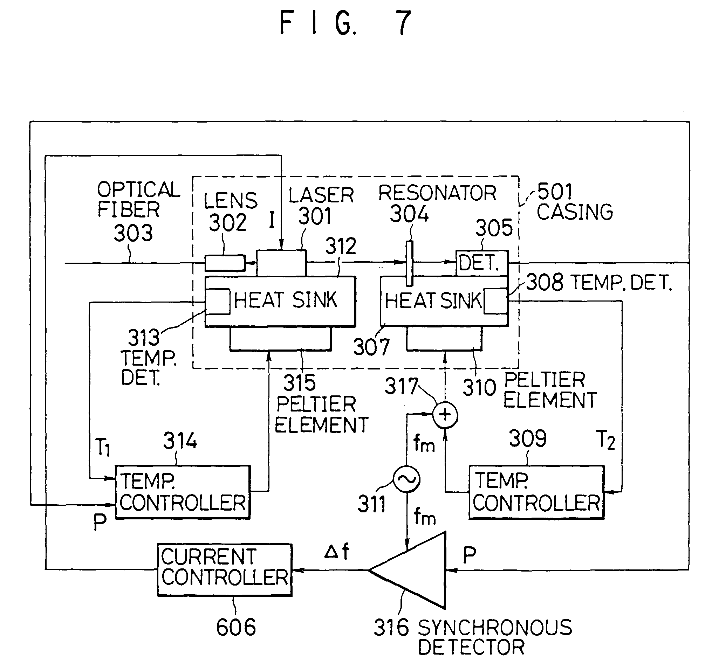

Fig.7 shows a frequency-stabilized light source according to a second embodiment, in which the temperature of the semiconductor laser 301 is controlled so that the output light power of the laser 301 is kept constant and the driving current for the laser 301 is controlled so that the oscillation frequency of the output light beam is kept constant.

In Fig. 7, the same reference numerals as those in Fig. 5 are attached to the corresponding elements for the sake of simplification of description and illustration.

Different from the first embodiment in Fig. 5, a current controller 606 is arranged between the synchronous detector 316 and the semiconductor laser 301.

The first temperature controller 314 receives an electric signal corresponding to the temperature $T_1$ of the first heat sink 312 from the first temperature detector 313. On the other hand, the first temperature controller 314 receives an electric signal corresponding to the output light power P from the photodetector 305. Based on the signals thus received, the controller 314 controls the driving current for the first Peltier element 315 to increase or decrease the temperature of the first heat sink 312.

Thus, the output light power of the semiconductor laser 301 is controlled to be kept constant.

The electrical output signal corresponding the detected power P of the output light, which is outputted from the photodetector 305, is sent to the synchronous detector 316. The detector 316 detects the signal thus sent synchronously with the modulation frequency $f_m$ from the oscillator 311 and produces an electric signal proportional to the frequency difference $\Delta f$. The signal thus produced is then sent to the current controller 606.

The output signal from the second temperature controller 309 is slightly modulated by a modulation signal whose frequency is $f_m$ and is sent to the second Peltier element 310.

The current controller 606 controls a driving current I for the laser 301 so that the oscillation frequency of the laser 301 is kept constant.

Thus, the temperature of the optical resonator 304 is modulated by the modulation signal from the oscillator 311 and at the same time, the temperature is controlled so that the time average of the temperature is kept constant.

In the second embodiment, the same effects or advantages as those in the first embodiment can be obtained.

In the present invention, any control means such as analog control means using the PID control method, digital control means using micro computers or the like can be employed as the controllers above described.

It is needless to say that the present invention is not restricted to the above first and second embodiments, and any other variations can be made within the scope of the claims.

## Claims

1. A frequency stabilization method for a semiconductor laser (301), said method comprising the steps of:

   injecting an output light beam from a semiconductor laser (301) into an optical resonator (304) to produce a transmitted light having a peak frequency of said optical resonator (304); detecting said transmitted light beam having said peak frequency to produce an output signal representing a detected power of said transmitted light beam; controlling said semiconductor laser with a first controller (314) such that the average said power of said transmitted light beam be kept constant based on said output signal, thereby keeping the power of said output light beam from said semiconductor laser constant ; and controlling with a second controller (606) the oscillation frequency of said semiconductor laser (301) to be in accordance with said peak frequency based on said output signal.

2. A frequency-stabilized light source comprising

   a semiconductor laser (301) emitting an output light beam; an optical resonator (304) into which said output light beam is injected; said resonator (304) producing a transmitted light beam and having a peak frequency of said optical resonator; a detector (305) for detecting said transmitted light beam to produce an output signal representing a detected power of said transmitted light beam; a first controller (314) for controlling said semiconductor laser such that the average said power of said transmitted light beam be kept constant based on said output signal, thereby keeping the power of said output light beam from said semiconductor laser constant ; and a second controller (606) for controlling the oscillation frequency of said semiconductor laser (301) to be in accordance with said peak frequency based on said output signal.

## Patentansprüche

1. Verfahren zur Frequenzstabilisierung eines Halbleiterlasers (301), wobei das Verfahren die Schritte aufweist:

   Injizieren eines Ausgabelichtstrahls eines Halbleiterlasers (301) in einen optischen Resonator (304) zur Erzeugung übertragenen Lichts mit einer Spitzenfrequenz des optischen Resonators (304), Detektieren des übertragenen Lichtstrahls mit der Spitzenfrequenz zur Erzeugung eines Ausgabesignals, das eine detektierte Leistung des übertragenen Lichtstrahls wiedergibt, Steuern des Halbleiterlasers mit einer ersten Steuerung (314) derart, daß die mittlere Leistung des übertragenen Lichtstrahls konstant gehalten wird, basierend auf dem Ausgabesignal, wodurch die Leistung des Ausgabelichtstrahls von dem Halbleiterlaser konstant gehalten wird, und Steuern der Oszillationsfrequenz des Halbleiterlasers (301) basierend auf dem Ausgabesignal mit einer zweiten Steuerung (606), um in Übereinstimmung mit der Spitzenfrequenz zu sein.

2. Frequenzstabilisieite Lichtquelle mit

   einem Halbleiterlaser (301), der einen Ausgabelichtstrahl emittiert, einem optischen Resonator (304), in den der Ausgabelichtstrahl injiziert wird, wobei der Resonator (304) einen übertragenen Lichtstrahl mit einer Spitzenfrequenz des optischen Resonators erzeugt, einem Detektor (305) zum Detektieren des übertragenen Lichtstrahls und zum Erzeugen eines Ausgabesignals, das eine detektierte Leistung des übertragenen Lichtstrahls wiedergibt, einer ersten Steuerung (314) zum Steuern des Halbleiterlasers derart, daß die mittlere Leistung des übertragenen Lichtstrahls konstant gehalten wird, basierend auf dem Ausgabesignal, wodurch die Leistung des Ausgabelichtstrahls von dem Halbleiterlaser konstant wird, und einer zweiten Steuerung (606) zum Steuern der Oszillationsfrequenz des Halbleiterlasers (301), um in Übereinstimmung mit der Spitzenfrequenz zu sein, basierend auf dem Ausgabesignal.

## Revendications

1. Procédé de stabilisation de fréquence pour un laser à semiconducteur (301), ledit procédé comprenant les étapes suivantes :

   injection d'un faisceau de lumière de sortie en provenance d'un laser à semiconducteur (301) dans un résonateur optique (304) pour produire une lumière transmise comportant une fréquence de crête dudit résonateur optique (304) ;

détection du faisceau de lumière transmis comportant ladite fréquence de crête pour produire un signal de sortie représentant une puissance détectée dudit faisceau de lumière transmis ;

commande dudit laser à semiconducteur par une première unité de commande (314) de sorte que la moyenne de ladite puissance dudit faisceau de lumière transmis soit conservée constante sur la base dudit signal de sortie, conservant ainsi constante la puissance dudit faisceau de lumière de sortie en provenance dudit laser à semiconducteur ; et

commande par une deuxième unité de commande (606) de la fréquence d'oscillation dudit laser à semiconducteur (301) en fonction de ladite fréquence de crête sur la base dudit signal de sortie.

2. Source de lumière à fréquence stabilisée comprenant :

un laser à semiconducteur (301) émettant un faisceau de lumière de sortie ;

un résonateur optique (304) dans lequel ledit faisceau de lumière de sortie est injecté ;

ledit résonateur (304) produisant un faisceau de lumière transmis et comportant une fréquence de crête dudit résonateur optique ;

un détecteur (305) pour détecter ledit faisceau de lumière transmis pour produire un signal de sortie représentant une puissance détectée dudit faisceau de lumière transmis ;

une première unité de commande (314) pour commander ledit laser à semiconducteur de sorte que la moyenne de ladite puissance dudit faisceau de lumière transmis soit conservée constante sur la base dudit signal de sortie, conservant ainsi constante la puissance dudit faisceau de lumière de sortie en provenance dudit laser à semiconducteur ; et

une deuxième unité de commande (606) pour commander la fréquence d'oscillation dudit laser à semiconducteur (301) en fonction de ladite fréquence de crête sur la base dudit signal de sortie.

# F I G. 1

POWER SUPPLY
709

PID
CONTROLLER
707

703 OSCILLATOR

LASER
701

LOCK-IN AMP.

706

705
DETECTOR

708
LENS

702 TEMP.
CONTROLLER

704
GAS CELL

# F I G. 2

803 LASER

THERMOSTATIC
BATH
801

802
PELTIER
ELEMENT

$V_F$

+
−

805
DIF. AMP.

TEMP.
CONT.

806

804
CURRENT
SOURCE

# F I G. 3

EP 0 746 069 B1

# F I G. 3A

# F I G.  4

# F I G. 5

# F I G. 6

# F I G. 7